(19) Europäisches Patentamt
European Patent Office
Office européen des brevets

(11) EP 1 751 233 B1

(12) EUROPEAN PATENT SPECIFICATION

(45) Date of publication and mention of the grant of the patent:
**11.03.2009 Bulletin 2009/11**

(21) Application number: **05743215.5**

(22) Date of filing: **18.05.2005**

(51) Int Cl.:
***C08L 65/00*** *(2006.01)* ***C08L 79/02*** *(2006.01)*
***C08L 101/12*** *(2006.01)* ***H01B 1/12*** *(2006.01)*
***H01L 51/30*** *(2006.01)*

(86) International application number:
**PCT/JP2005/009491**

(87) International publication number:
**WO 2005/113678 (01.12.2005 Gazette 2005/48)**

(54) **ELECTROCONDUCTIVE COMPOSITION AND APPLICATION THEREOF**

ELEKTRISCH LEITFÄHIGE ZUSAMMENSETZUNG UND ANWENDUNG DAVON

COMPOSITION ÉLECTROCONDUCTIVE ET SON APPLICATION

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **21.05.2004 JP 2004151154**
**10.08.2004 JP 2004232851**

(43) Date of publication of application:
**14.02.2007 Bulletin 2007/07**

(73) Proprietor: **SHOWA DENKO KABUSHIKI KAISHA**
**Tokyo 105-8518 (JP)**

(72) Inventors:
- **OHKUBO, Takashi,**
  **c/o SHOWA DENKO KK,**
  **CORP. R & D**
  **Chiba-shi Chiba 267-0056 (JP)**
- **SAIDA, Yoshihiro,**
  **OMACHI PLANT, SHOWA DENKO K.K.**
  **Nagano 398-0002 (JP)**
- **TANAKA, Jun,**
  **c/o SHOWA DENKO K.K.**
  **Minato-ku, Tokyo 105-8518 (JP)**

(74) Representative: **Strehl Schübel-Hopf & Partner**
**Maximilianstrasse 54**
**80538 München (DE)**

(56) References cited:
**EP-A- 0 662 694** **WO-A-01/18888**
**US-A- 5 641 859** **US-A- 5 688 873**

- **DATABASE CA [Online] CHEMICAL ABSTRACTS SERVICE, COLUMBUS, OHIO, US; 18 September 1998 (1998-09-18), SAITA, YOSHIHIRO ET AL: "Leak-free electrochromic device comprising gel or solid electrolyte containing self-doping electroconductive polymer" XP002337796 retrieved from STN Database accession no. 1998: 594721 -& JP 10 239715 A (SHOWA DENKO K. K., JAPAN) 11 September 1998 (1998-09-11)**
- **DATABASE CA [Online] CHEMICAL ABSTRACTS SERVICE, COLUMBUS, OHIO, US; 10 April 2001 (2001-04-10), SAITO, TAKASHI ET AL: "Manufacture of water-resistant electroconductors from water-soluble polyanilines" XP002337797 retrieved from STN Database accession no. 2001:252964 -& JP 2001 098069 A (MITSUBISHI RAYON CO., LTD., JAPAN) 10 April 2001 (2001-04-10)**
- **DATABASE CA [Online] CHEMICAL ABSTRACTS SERVICE, COLUMBUS, OHIO, US; 3 July 1998 (1998-07-03), SAITA, YOSHIHIRO ET AL: "Self-doping electroconductive polymer composition" XP002337798 retrieved from STN Database accession no. 1998:407628 -& JP 10 168328 A (SHOWA DENKO K. K., JAPAN) 23 June 1998 (1998-06-23)**
- **DATABASE WPI Section Ch, Week 200211 Derwent Publications Ltd., London, GB; Class A85, AN 2002-078319 XP002337950 -& JP 2001 270999 A (MITSUBISHI RAYON CO LTD) 2 October 2001 (2001-10-02)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



(Cont. next page)

Remarks:

The file contains technical information submitted after the application was filed and not included in this specification

## Description

### TECHNICAL FIELD

The present invention relates to an electroconductive composition containing an aqueous solvent-soluble electroconductive polymer and an additive for improving the electroconductivity of the polymer.

More specifically, the present invention relates to an electroconductive composition containing an aqueous solvent-soluble electroconductive polymer and an aqueous solvent-soluble resin, which are not affected by use environment such as dry conditions and can be applied to surface antistatic treatment of low resistance.

Further, the present invention relates to coating materials, coating films, coated products and organic electronics devices using the electroconductive composition described above.

### BACKGROUND ART

Recently, there are increased demands on imparting electroconductivity to non-electroconductive substrates for the purpose of antistatic treatment or electromagnetic shielding.

In an earlier stage, compositions, resins and the like where metal powders, graphite powers and the like are mixed or dispersed as electroconductive fillers were used, however, such materials involves problems that highly advanced technique is required for dispersion and that thin films cannot be formed from such a material.

In view of the above, surfactants or polymers having n-electron conjugation system have been proposed as an organic electroconductive material for antistatic purposes.

Generally, plastic products such as molded products and films made of various plastic materials are highly electrically insulative and susceptible to troubles such as taints, deterioration of functions and other damages incurred due to dusts collected by static electricity or due to occurrence of electric discharge during fabrication process or in the use thereof.

In order to prevent such electrostatic troubles, such conventional plastic products are subjected to antistatic treatment of forming an electroconductive film on the surface of plastics.

As electroconductive material, antistatic agents of various surfactant types, such as those having anionic, cationic and nonionic property have been used, and the function of such existing antistatic agents is such that the antistatic agent bleeds out on the surface of synthetic resin molded products and forms an electroconductive layer with hygroscopic water content therein on the surface of the synthetic resin molded products to thereby promote dispersion or elimination of charges.

Accordingly, the effect of such an antistatic agent depends on the humidity of the circumstance in which it is used and therefore, there is a problem that since the water amount adsorbed to the antistatic agent is extremely decreased under low humidity circumstance where many electrostatic troubles occur, the antistatic effect is lost.

One example of materials for solving the problem described above is an electroconductive polymer. Since the electroconductive polymer is a polymer having $\pi$-electron conjugation system and its electroconductive mechanism is electron conduction, this material is capable of providing antistatic performance even under low humidity circumstance.

In view of the above, electroconductive polymers such as polythiophene or polyaniline have been attracting attention and it has been proposed to form polymer films by polymerizing the same.

However, since an electrolytic oxidative polymerization method or chemical oxidative polymerization method used as a method of rendering an electroconductive polymer highly electroconductive requires a high cost and involves washing steps, such a material is not suitable for various applications and use thereof is limited.

On the other hand, there are many application uses of forming a thin electroconductive film on an insulative substrate and, while a method of dissolving an electroconductive polymer compound such as a soluble polythiophene or polyaniline in a solvent and coating the electroconductive material on an insulative substrate has been practiced as a method of forming the electroconductive polymer film, the coated film has high resistance and a great amount of electroconductive polymer is necessary for decreasing the resistance.

For the electroconductive coating material, thickening agent or binder is appropriately used as general additives (JP-A-2000-95970 and JP-A-2003-213148). Addition of thickening agent or binder causes increase in viscosity of the electroconductive coating material, which leads to increased thickness of the coating film and decrease in surface resistance, however, no effect of improving the electroconductivity of the electroconductive composition by addition of thickening agent or binder is known. On the other hand, a thickening agent, a binder or the like is added in order to control the wettability for the substrate to be used and the thickness of the film to be formed thereon, addition of such non-conductive additives involves a problem that the electroconductivity of the material is decreased.

Further, also in a case of using an insoluble electroconductive polymer in a dispersed state (JP-A-Hei 11-291410), use of thickening agent and/or binder, instead of contributing to improvement of the electroconductivity thereof, induces reduction in the electroconductivity of the coating film.

It is known that charge-up of electrons derived from the electron beam often causes errors in positioning in electron beam lithography process, and as an agent for preventing charge-up, coating material of water-soluble electroconductive polymer is used. Further, since resists patterned according to recent design rule with smaller minimum line width are liable to fall down, thickness of resist film tends to be made small in order to prevent resists from falling down. Under these circumstances, there is a concern that such a coating film for preventing charge-up in electron beam lithography adversely affects the resist sensitivity and the pattern precision, and there is a demand for reduction in film thickness of the charge-up preventing film.

An anode buffer layer of an organic light emitting device (hereinafter simply referred to as OLED) can be mentioned as an example where an electroconductive polymer is applied to an organic electronics device. In a case of a polymer-type organic light emitting device, it has a device structure constituted by transparent substrate/transparent electrode (anode)/anode buffer layer/light emitting layer/cathode. The anode buffer is required to provide effects of preventing short-circuit caused by the roughness on the surface of the transparent electrode and of alleviating the hole injection barrier.

At present, a mixture of poly(3,4-ethylene dioxy thiophene)(PEDOT) as an electroconductive polymeric material and polystyrene sulfonic acid (PPS) as an external is used generally for the anode buffer layer, but it involves a problem that polystyrene sulfonic acid intrudes into the light emitting layer to deteriorate the light emitting layer.

A method of using a self-doped type electroconductive polymer not containing an external dopant for the anode buffer layer is disclosed, and the disclosure includes only self-doped type sulfonatedpolyaniline as most preferred by referring to its embodiments and examples. (JP-A-2003-509816 (WO01/018888)).

a) Database CA [Online] Chemical Abstracts Service, Columbus, Ohio, US; 18 September 1998 (1998-09-18), Saita, Yoshihiro et al.: "Leak-free electrochromic device comprising gel or solid electrolyte containing self-doping electroconductive polymer", XP002337796, retrieved from STN Database accession no. 1998:594721 & b) JP10239715 A (Showa Denko K. K.) 11 September 1998 disclose a device containing a pair of electrodes and a polymer electrolyte which comprises a self-doping electroconductive polymer having Bronsted acid groups and an N-vinylacetamide polymer between the electrodes. The self-doping electroconductive polymers exhibit electrochromic properties.

US 5 688 873 A (Saida et al.) 18 November 1997 (1997-11-18) discloses compositions comprising a water-soluble polymer having a sulfonated 1,3-dihydroisothianaphthene as monomeric building block in polymerised form and poly(vinyl alcohol).

a) Database WPI Section Ch, Week 200211 Derwent Publications Ltd., London, GB; Class A85, AN 2002-078319 XP002337950 & b) JP 2001 270999 A (Mitsubishi Rayon Co., Ltd.) 2 October 2001 (2001-10-02) disclose electroconductive compositions which comprise a water-soluble conductive polymer and an additional water-soluble polymer such a acrylic styrene resins. The compositions are useful for producing conductors having good water resistance and good adhesion.

## DISCLOSURE OF THE INVENTION

The object of the present invention is to provide an electroconductive polymer soluble in aqueous solvent and excellent in elecroconductivity, which is applicable to surface antistatic treatment with low resistance without being influenced by use environment such as dryness, and also provide an electroconductive composition using the polymer.

The present inventors have made various studies for solving the subjects described above and, as a result, have found that the electroconductivity of the electroconductive polymer is improved by adding an aqueous solvent-soluble resin to an aqueous solvent-soluble electroconductive polymer, particularly, to a water soluble electroconductive polymer,andhave accomplished the present invention.

That is, the present invention relates to the following electroconductive composition, electroconductive coating materials, electroconductive coating film, articles coated by the film, method for forming a pattern, organic electronic device and organic light-emitting device.

(1) An electroconductive composition comprising an aqueous solvent-soluble electroconductive polymer containing a chemical structure shown by formula (1)

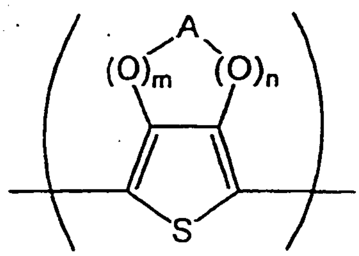

(1)

wherein m and n each independently represent 0 or 1, A represents an alkylene or alkenylene group having 1 to 4 carbon atoms (which may have two double bonds) which has at least one substituent represented by $-B-SO_3^-M^+$, and the alkylene group and the alkenylene group may have each as a substituent, a linear or branched, saturated or unsaturated hydrocarbon group having 1 to 20 carbon atoms, a linear or branched, saturated or unsaturated alkoxy group having 1 to 20 carbon atoms, a linear or branched alkylester group having 1 to 20 carbon atoms, a hydroxyl group, a halogen atom, a nitro group, a cyano group, a trihalomethyl group or a phenyl group which may be substituted, B represents $-(CH_2)_p-(O(CH_2)_q)_r-$, p is 0 or an integer of 1 to 5, q is an integer of 1 to 3, and r is 0 or an integer of 1 to 3, and $M^+$ represents $H^+$, an alkali metal ion or a quaternary ammonium ion, and an aqueous solvent-soluble resin, which is at least one selected from a group consisting of cellulose ether and polyethylene oxide, wherein the increase ratio in the electroconductivity in the composition is 1 or more based on the electroconductivity of the aqueous solvent-soluble electroconductive polymer.

(2) The electroconductive composition according to (1) above, wherein the aqueous solvent-soluble electroconductive polymer is a water soluble electroconductive polymer containing a chemical structure represented by the following general formula (2)

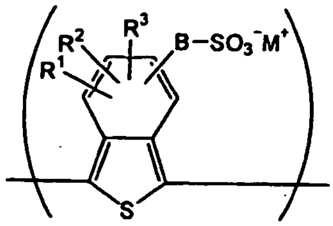

(2)

wherein $R^1$ to $R^3$ each independently represent a hydrogen atom, a linear or branched, saturated or unsaturated hydrocarbon group having 1 to 20 carbon atoms, a linear or branched, saturated or unsaturated alkoxy group having 1 to 20 carbon atoms, a linear or branched alkyl ester group having 1 to 20 carbon atoms, a hydroxyl group, a halogen atom, a nitro group, a cyano group, a trihalomethyl group, a phenyl group which may be substituted, or a $-B-SO_3^-M^+$ group, the alkyl group, the alkoxy group or the alkyl ester group as $R^1$, $R^2$ and $R^3$ described above may have, in the chain thereof, a carbonyl bond, an ether bond, an ester bond, a. sulfonate ester bond, an amide bond, a sulfonamide bond, a sulfide bond, a sulfinyl bond, a sulfonyl bond or an imino bond, B represents $-(CH_2)_p-(O(CH_2)_q)_r-$, p is 0 or an integer of 1 to 5, q is an integer of 1 to 3, r is 0 or an integer of 1 to 3, and $M^+$ represents $H^+$, an alkali metal ion or a quaternary ammonium ion.

(3) The electroconductive composition according to (1) or (2) above, wherein the cellulose ether is hydroxypropyl cellulose.

(4) The electroconductive composition according to (1), (2) or (3) above, wherein 0.05 to 20 parts by mass of the aqueous solvent-soluble resin is contained based on 1 part by mass of the aqueous solvent-soluble electroconductive polymer.

(5) An electroconductive coating material using the electroconductive composition according to any one of (1) to (4) above.

(6) An electroconductive coating film using the electroconductive composition according to any one of (1) to (4) above.

(7) A coated article which is coated with the electroconductive composition according to any one of (1) to (4) above.

(8) The coated article according to (7) above, wherein the surface of the base substrate is a coating of a photosensitive composition or a composition sensitive for charged particle beam.

(9) A method for forming a pattern, using the electroconductive coating film according to (6) above.

(10) An organic electronic element using an anode buffer layer containing the electroconductive composition according to any one of (1) to (4) above.

(11) An organic light emitting element using an anode buffer layer containing the electroconductive composition according to any one of (1) to (4) above.

(12) The organic light emitting element according to (11), wherein the light emitting layer of the organic light emitting element comprises a fluorescent polymer.

(13) The organic light emitting element according to (11) above, wherein the light emitting layer of the organic light emitting element comprises a phosphorescent polymer.

**BRIEF DESCRIPTION OF THE DRAWINGS**

Fig.1 shows a cross sectional view of an example of an organic light emitting element according to the present invention.

Fig.2 shows an example of a structure of a phosphorescent light emitting portion and a carrier transporting portion of a non-conj ugated type phosphorescent light emitting polymer used in the organic light emitting element of the present invention.

**DETAILED DESCRIPTION OF THE INVENTION**

The term "electroconductivity" as used in the present invention is defined as the reciprocal of the constant of proportion (resistivity) in a formula showing relationship between the geometric form of a test sample and resistance value according to Ohm' s law. (The unit is defined as $(\Omega m)^{-1}$, and when "1/Ω" is designated as "S (Siemens) ", the unit can be represented by "$Sm^{-1}$".)

In the present invention, "electroconductivity increase ratio" is a value obtained by dividing an adjusted electroconductivity value which is a quotient resulting from the division of an electroconductivity value of the electroconductive composition containing an aqueous solvent-soluble electroconductive polymer and an aqueous solvent-soluble resin by the dilution ratio of the aqueous solvent-soluble resin, by an electroconductivity value of an aqueous solvent-soluble electroconductive polymer containing no aqueous solvent-soluble resin. When the electroconductivity of the aqueous solvent-soluble electroconductive polymer is ρ (a), the electroconductivityof the electroconductive composition of the present invention is p (c), the mass part of the aqueous solvent-soluble electroconductive polymer is a, and the mass part of the aqueous solvent-soluble resin is b, the value of the electroconductivity increase ratio can be calculated by the following formula.

$$\text{electroconductivity increase ratio} = \rho\,(c)/\rho\,(a)/\{a/(a+b)\}$$

In the formula, "a/ (a+b)" is the dilution ratio, i.e. the ratio of the aqueous solvent-soluble electroconductive polymer in the mixture of the aqueous solvent-soluble electroconductive polymer with the aqueous solvent-soluble resin.

In the present invention, the electroconductivity of the aqueous solvent-soluble resin is sufficiently low as compared to that of the aqueous solvent-soluble electroconductive polymer. Here, "sufficiently small" means that elctron conductivity is neglectable as compared to that of the aqueous solvent-soluble electroconductive polymer, and the meaning does not include ionic conductivity. Specifically speaking, such a low electroconductivity is an electroconductivity of 1/1000 or less the electroconductivity of the aqueous solvent-soluble electroconductive polymer.

Specific aqueous solvent-soluble resins improving the electroconductivity of the aqueous solvent-soluble electroconductive polymer are polyethylene oxide and cellulose ether.

In a case where an electroconductive coating material using the electroconductive composition is produced in the present invention, for the purpose of adjusting viscosity of the electroconductive coating material containing an aqueous solvent (water or a solvent miscible in water), viscosity improvers of different viscosity indices which contain aqueous solvent-soluble resin may be used in combination.

In order to obtain a high electroconductivity, it is .preferable that the mixing ratio of the aqueous solvent-soluble electroconductive polymer/the aqueous solvent-soluble resin be adjusted such that 0.1 to 20 parts by mass of the aqueous solvent-soluble resin is added to 1 part by mass of the aqueous solvent-soluble electroconductive polymer, and, more preferably, 0.5 to 10 parts by mass of the aqueous solvent-soluble resin is added to 1 mass part of the aqueous solvent-soluble electroconductive polymer.

The contents of the aqueous solvent-soluble electroconductive polymer and the aqueous solvent-soluble resin in a conductive composition depend on the viscosity of the electroconductive coating material, however it is preferable

that the total amount of the aqueous solvent-soluble electroconductive polymer and the aqueous solvent-soluble resin be from 0.05 to 50 parts by mass against 100 parts by mass of the aqueous solvent, more preferably, from 0.1 to 10 parts by mass.

Although some aqueous solvent-soluble resins dedope aqueous solvent-soluble electroconductive polymer, the aqueous solvent-soluble resin used in the electroconductive composition of the present invention changes morphology of the aqueous solvent-soluble electroconductive polymer. Even the aqueous solvent-soluble resin is a type which dedopes the aqueous solvent-soluble electroconductive polymer, by appropriately adjusting the added amount of aqueous solvent-soluble resin to an optimum, the film formed of the electroconductive composition of the present invention can obtain enhanced electroconductivity, i.e., an electroconductivity increase ratio of 1 or more, as compared to a film formed of the aqueous solvent-soluble electroconductive polymer alone.

The coating film using an electroconductive coating material containing the electroconductive composition of the present invention is dried after formation of the film. The drying may be conducted naturally in the air or may be conducted with heat. It is preferable that the drying temperature be lower than the temperature incurring structural change of the aqueous solvent-soluble electroconductive polymer.

Basically, the water soluble electroconductive polymer used in the invention is not limited, so long as it is a π-conjugated type electroconductive polymer having a Broensted acid group and it is water soluble. The water soluble electroconductive polymer may be a self-doped electroconductive polymer where the Broensted acid group is bonded directly to the π-electron conjugated main chain, or bonded by way of a spacer such as an alkylene side chain and an oxyalkylene side chain, and is not always restricted by the primary structure of the chemical structure.

Specific examples of water soluble electroconductive polymers include copolymers having repeating units such as poly (isothianaphthene sulfonic acid), poly(thiophene alkane sulfonic acid), poly(thiophene oxyalkane sulfonic acid), poly(pyrrole alkyl sulfonic acid), and poly(aniline sulfonic acid), and various kinds of salt structures and substituted derivatives thereof.

Further, the repeating unit of the chemical structure containing a sulfonic acid group in the copolymer is usually present within a range from 100 to 50 mol%, preferably from 100 to 80 mol% of the total repeating units in the polymer, and the polymer may be a copolymer containing repeating units of other π conjugated type chemical structures or may be composed of 2 to 5 kinds of repeating units.

Further, in the invention, "a copolymer containing repeating units" is not always limited to a copolymer containing the units continuously, but means a polymer like a random copolymer containing irregular or discontinuous repeating units in a π conjugated type main chain so long as a desired electroconductivity based on the π conjugated type main chain can be exhibited.

The structures used in the present invention are represented by formulae (1) and (2). The electroconductive polymer may be a homopolymer or a copolymer thereof as described above.

Formula (1):

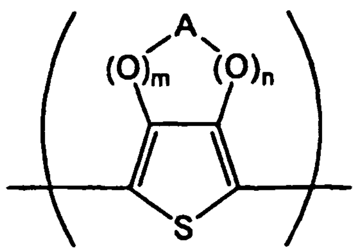

(1)

In the formula, m and n each independently represent 0 or 1, A represents an alkylene or alkenylene group having 1 to 4 carbon atoms (which may have two or more double bonds) and having at least one substituent represented by $-B-SO_3^-M^+$. The alkylene and the alkenylene groups may have, as a substituent, a linear or branched, saturated or unsaturated hydrocarbon group having 1 to 20 carbon atoms, a linear or branched, saturated or unsaturated alkoxy group having 1 to 20 carbon atoms, a linear or branched alkyl ester group having 1 to 20 carbon atoms, a hydroxyl group, a halogen atom, a nitro group, a cyano group, a trihalomethyl group or a phenyl group which may be substituted. B represents $-(CH_2)_p-(O(CH_2)_q)_r-$, p represents 0 or an integer of 1 to 5, q is an integer of 1 to 3, r is 0 or an integer of 1 to 3, and $M^+$ represents $H^+$, an alkali metal ion or a quaternary ammonium ion.

Formula (2):

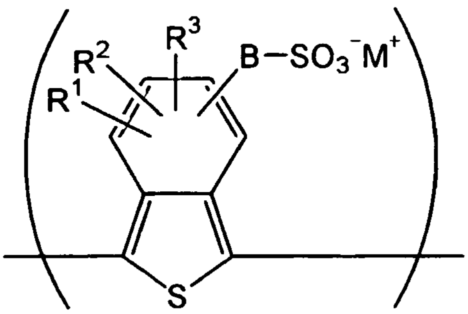

(2)

In the formula, $R^1$ to $R^3$ each independently represents a hydrogen atom, a linear or branched, saturated or unsaturated hydrocarbon group having 1 to 20 carbon atoms, a linear or branched, saturated or unsaturated alkoxy group having 1 to 20 carbon atoms, a linear or branched alkyl ester group having 1 to 20 carbon atoms, a hydroxyl group, a halogen atom, a nitro group, a cyano group, a trihalomethyl group, a phenyl group which may be substituted, or a $-B-SO_3^-M^+$ group, the alkyl group, the alkoxy group or the alkyl ester group as $R^1$, $R^2$ and $R^3$ described above may have, in the chain thereof, a carbonyl bond, an ether bond, an ester bond, a sulfonate ester bond, an amide bond, a sulfonamide bond, a sulfide bond, a sulfinyl bond, a sulfonyl bond or an imino bond, B represents $-(CH_2)_p-(O(CH_2)_q)_r-$, p is 0 or an integer of 1 to 5, q is an integer of 1 to 3, r is 0 or an integer of 1 to 3, and $M^+$ represents $H^+$, an alkali metal ion or a quaternary ammonium ion.

Particularly useful examples of $R^1$ to $R^6$ in formula (2) include a hydrogen atom, an alkyl group, an alkoxy group, an alkylester group, a phenyl group which may be substituted and a sulfonic acid group.

Specific examples of the substituent include:

as the alkyl group, methyl, ethyl, propyl, allyl, isopropyl, butyl, 1-butenyl, pentyl, hexyl, heptyl, octyl, nonyl, decyl, undecyl, dodecyl, tetradecyl, hexadecyl, ethoxyethyl, methoxyethyl, methoxyethoxyethyl, acetonyl and phenacyl,
as the alkoxy group, methoxy, ethoxy, propoxy, isopropoxy, butoxy, pentyloxy, hexyloxy, octyloxy, dodecyloxy, methoxyethoxy and methoxyethoxyethoxy,
as the alkyl ester group, alkoxy carbonyl groups such as methoxycarbonyl, ethoxycarbonyl and buthoxycarbonyl and acyloxy groups such as acetoxy and buthyloyloxy,
as the substituted phenyl group,fluorophenyl group, chlorophenyl group, bromophenyl group, methylphenyl group and methoxyphenyl group. The alkyl group and the alkoxy group as $R^1$ to $R^5$ described above may have, in the chain thereof, a carbonyl bond, an ether bond, an ester bond, a sulfonate ester bond, an amide bond, a sulfonamide bond, a sulfide bond, a sulfinyl bond, a sulfonyl bond or an imino bond.

Among the specific examples of the substituents of $R^1$ to $R^5$ in formula (2), a hydrogen atom, and an alkyl group, an alkoxy group and an alkyl ester group each having 1 to 20 carbon atoms which may be either linear or branched are preferred. Further among them, a hydrogen atom and a linear or branched alkoxy group having 1 to 20 carbon atoms are particularly preferred.

Examples of B in formula (1) or (2) include butylene, pentylene, hexylene, methylenedioxy and ethylenedioxy.

$M^+$ in the general formula (1) or (2) represents $H^+$, an alkali metal ion, a quaternary ammonium ion, and may be a mixture containing one or more of those cations.

Examples of alkali metal ion include $Na^+$, $Li^+$ and $K^+$.

The quaternary ammonium ion is represented by $N (R^7) (R^8) (R^9) (R^{10})^+$, in which $R^7$ to $R^{10}$ each independently represents a hydrogen atom, a linear or branched, saturated or unsaturated alkyl group of 1 to 30 carbon atoms or a substituted or unsubstituted aryl group, or may be an alkyl or aryl group which contains a group including elements other than carbon and hydrogen, such as an alkoxy group, a hydroxyl group, a oxyalkylene group, a thioalkylene group, an azo group, an azobenzene group and a p-diphenylene group.

As a cation of the quaternary ammonium represented by $N(R^7) (R^8) (R^9) (R^{10})^+$, an unsubstituted, alkyl-substituted or aryl-substituted cation, for example, $NH_4^+$, $NH (CH_3)_3^+$, $NH (C_6H_5)_3^+$, $N(CH_3)_2(CH_2OH) (CH_2-Z)^+$ is used (In the chemical formula, Z represents an optional substituent having a chemical formula weight of 600 or less (such as a phenoxy group, p-diphenyleneoxy group, p-alkoxydiphenyleneoxy group and p-alkoxy phenyl azophenoxy group)). Further, in order to convert into a specified cation, ordinary ion exchange resins may be used.

The alkyl group of $R^7$ to $R^{10}$ may have, in the chain thereof, a carbonyl bond, an ether bond, an ester bond, an amide bond, a sulfide bond, a sulfinyl bond, a sulfonyl bond, and an imino bond.

Specific usable examples of the constitutional unit containing the Broensted acid for constituting the water soluble electroconductive polymer of the invention include, as preferred examples of the chemical structures represented by formulae (1) and (2), 5-(3'-propane sulfo)-4,7-dioxycyclohexa [2,3-c]thiophene-1,3-diyl, 5-(2'-ethane sulfo)-4,7-dioxycyclohexa [2,3-c]thiophene-1,3-diyl, 5-sulfoisothianaphthene-1,3-diyl, 4-sulfoisothianaphthene-1,3-diyl, 4-methyl-5-sulfoisothianaphthene-1,3-diyl, 6-methyl-5-sulfoisothianaphthene-1,3-diyl, 6-methyl-4-sulfoisothianaphtehen-1,3-.diyl, 5-methyl-4-sulfoisothianathene-1,3-diyl, 6-ethyl-5-sulfoisothianaphthene-1,3-diyl; 6-propyl-5-sulfoisothianaphthene-1,3-diyl, 6-butyl-5-sulfothianaphthene-1,3-diyl, 6-hexyl-5-sulfoisothianaphthene-1,3-diyl, 6-decyl-5-sulfoisothianaphthene-1,3-diyl, 6-methoxy-5-sulfoisothianaphthene-1,3-diyl, 6-ethoxy-5-sulfoisothianaphthene-1,3-diyl, 6-chloro-5-sulfoisothianaphtene-1,3-diyl, 6-bromo-5-sulfoisothianaphthene-1,3-diyl, 6-trifluoromethyl-5-sulfoisothianaphtehen-1,3-diyl, and lithium salts, sodium salts, ammonium salts, methyl ammonium salts, ethyl ammonium salts, dimethyl ammonium salts, diethyl ammonium salts, trimethyl ammoniumsalts, triethyl ammonium salts, tetramethyl ammonium salts and tetraethyl ammonium salts thereof.

The molecular weight of the self-doped electroconductive polymer used in the invention can not always be flatly defined since it depends on the chemical structure of the constituting repeating units, and, it is not particularly limited so long as the molecular weight does not hinder the purpose of the invention. Generally, in terms of the number of repeating units (degree of polymerization) constituting the main chain, it is usually from 5 to 2000, preferably, from 10 to 1000.

Particularly preferred examples of the $\pi$ conjugated electroconductive polymer having the Broensted acid group include polymers of 5-sulfoisothianaphthene-1,3-diyl, random copolymers containing 80 mol% or more of 5-sulfoisothianaphthene-1,3-diyl, copolymer of 5-sulfoisothianaphthene-1,3-diyl and isothianaphthene-1,3-diyl, random copolymers containing 50 mol% or more of 2-sulfo-1, 4-iminophenylene, copolymer of 2-sulfo-1,4-iminophenylene and 1,4-iminophenylene, and lithium salts, sodium salts, ammonium salts, and lithium salts, sodium salts, ammonium salts, triethyl ammonium salts thereof.

In an electroconductive coating material containing the electroconductive composition of the invention, a solvent which is miscible with water and dissolves the self-doped electroconductive polymer without dedoping the same may be used to form an aqueous solvent. Examples of such a solvent include ethers such as 1,4-dioxane and tetrahydrofuran, carbonates such as dimethyl carbonate, diethyl carbonate, ethylene carbonate and propylene carbonate, nitriles such as acetonitrile and benzonitrile, alcohols such as methanol, ethanol, propanol and isopropanol, aprotonic polar solvents such as N, N-dimethyl formamide, dimethyl sulfoxide, and N-methyl-2-pyrrolidone, mineral acids such as sulfuric acid, and organic acids such as acetic acid. They may be used as a mixed solvent of two or more kinds.

In order to improve coatability of the aqueous solvent-soluble resin *per se* to be contained in the electroconductive coating material of the invention, other surfactants may further be added. Examples of such surfactants include anionic surfactants, cationic surfactants and nonionic surfactants.

Surfactants usable in the present invention are not particularly limited. Examples of anionic surfactant include alkyl ether carboxylic acid, linear-chained alkylbenzene sulfonic acid, alpha-olein sulfonic acid, alkane sulfonate, dialkylsulfosuccinic acid, naphthalene sulfonic acid formaldehyde condensate, alkyl sulfuric acid ester, polyoxyethylene alkyl ether sulfuric acid ester, polyoxyethylene alkylphenyl ether sulfuric acid ester, higher alcohol phosphoric acid ester, phosphoric acid ester of higher alcohol-ethylene oxide adduct and acyl-N-methyltaurine and can also include salts of these compounds when they are acid type.

Examples of cationic surfactant include monoalkylammonium chloride, dialkylammonium chloride, ethoxylated ammonium chloride, other special quaternary salts, alkylamine acetate salt, diaminedioleate salt and LAG/lauroyl amide guanidine.

Examples of nonionic surfactant include glycerin fatty acid esters (glyceryl stearate, glyceryl oleate), propylene glycol fatty acid ester, sorbitan fatty acid ester (sorbitan oleate, sorbitan stearate), sucrose fatty acid ester, polyethylene glycol fatty acid ester (glycol distearate), polyoxyethylene alkyl ether, alkyl glyceryl ether, polyoxyethylene alkylphenylether, polyoxyethylene polyoxypropylene ether, polyoxyalkylene alkyl ether, acetylene glycol, polyoxyethylene sorbitan fatty acid ester, polyoxyethylene sorbitol fatty acid ester (tetra oleic acid polyoxyethylene sorbit), alkylglycerylether (isostearylglyceryl), fatty acid alkylene oxide adduct, polyoxyethylene cured castor oil, fatty acid alkanolamide(lauric acid diethanolamide), fatty acid amide alkylene oxide adduct, amine EO adduct, amine PO adduct and diaminealkylene oxide adduct.

Examples of amphoteric surfactant include betaine lauryl dimethylamino acetate, betaine stearyl dimethylamino acetate, lauryl dimethylamine oxide, 2-alkyl-N-carboxymethyl-N-hydroxyethylimidazolinium betaine, lauric acid amide propyl betaine, lauryl hydroxyl sulfobetaine and alanine base surfactants.

Other high molecular weight surfactants, various high molecular weight dispersants, phospholipids (such as lecithin), saponin compounds, fluorochemical surfactants, silicone surfactants and the like may be used.

One kind of these surfactants may be used singly, or a mixture of two or more kinds may be used.

Examples of the electronic device using the conductive coating film in the present invention include an electronic device where the conductive coating filmof the invention is disposedbetween electrodes. Between electrodes, materials

other than the conductive coating film of the invention may be contained, or a laminate structure consisting of thin films formed of the conductive coating film of the invention and other thin films formed of other materials may be formed. As for the electronic device, a more specific example is an organic light-emitting element.

The organic light-emitting element in a preferred embodiment of the present invention is specifically described below by referring to the drawings.

Fig. 1 is a cross-sectional view showing one example of the construction for the organic light-emitting element of the present invention, where an anode buffer layer (3) and a light-emitting layer (4) are sequentially stacked between an anode (2) and a cathode (5) provided on a transparent substrate (1). The construction of the organic light-emitting element of the present invention is not limited to the example shown in Fig. 1, but further examples thereof include element constructions where one structure of

1) anode buffer layer/hole transport layer/light-emitting layer,
2) anode buffer layer/light-emitting layer/electron transport layer,
3) anode buffer layer/hole transport layer/light-emitting layer/electron transport layer,
4) anode buffer layer/layer containing hole transport material, light-emitting material and electron transport material,
5) anode buffer layer/layer containing hole transport material and light-emitting material and
6) anode buffer layer/layer containing light-emitting layer and electron transport material, is provided in this order between an anode and a cathode. Moreover, in Fig. 1, one light-emitting layer is provided, but the element may have two or more light-emitting layers.

The anode buffer layer in the organic light-emitting element of the present invention can be formed, for example, by coating a coating composition on a substrate having formed thereon anode and then heat-treating it to remove the solvent. As for the coating method, a spin coating method, an inkjet method, a printing method, a spray method, a dispenser method or the like can be used. The thickness of the anode buffer layer is preferably from 10 to 200 nm, more preferably from 20 to 100 nm.

The molecular weight of the water-soluble conductive polymer for use in the present invention is, in terms of the weight average molecular weight, preferably from 1,000 to 200,000, more preferably from 5,000 to 100,000.

As for compounds used for the light-emitting layer, hole transport layer and electron transporting layer in the organic light-emitting element of the present invention, either a low molecular compound or a polymer compound can be used. Since the anode buffer layer of the present invention is a polymer compound, a polymer compound is preferred from the standpoint of simplifying the element production process.

Examples of the light-emitting material constituting the light-emitting layer of the organic light-emitting element of the present invention include low molecular light-emitting materials and polymer light-emitting materials described in Hiroshi Omori, Oyo Butsuri (Applied Physics), Vol. 70, No. 12, pp. 1419-1425 (2001). Among these, phosphorescent materials are preferred in view of high light emission efficiency. Also, polymer light-emitting materials are preferred because the element production process is simplified. Accordingly, phosphorescence-emitting polymer compounds are more preferred.

The phosphorescence-emitting polymer compound used as the light-emitting layer of the organic light-emitting element of the present invention is not particularly limited in its structure as long as it is a polymer compound emittingphosphorescence at room temperature. Specific examples of the polymer structure to be firstly mentioned include polymer structures comprising a conjugated polymer skeleton such as poly(p-phenylenes), poly(p-phenylenevinylenes), polyfluorenes, polythiophenes, polyanilines, polypyrroles and polypyridines to which a phosphorescent moiety(representative examples thereof include monovalent or divalent groups of transition metal complex or rare earth metal complex described later) is bonded. In these polymer structures, the phosphorescent moietymay be incorporated into the main chain or into the side chain.

Other examples of the polymer structure for the phosphorescent polymer compound include polymer structures comprising anon-conjugated polymer skeleton such as polyvinylcarbazole and polysilanes, to which a phosphorescent moiety is bonded. In these polymer structures, the phosphorescent moiety may be incorporated into the main chain or into the side chain.

Still other examples of the polymer structure for the phosphorescent polymer compound include dendrimers having a phosphorescent moiety. In this case, the phosphorescent moiety may be incorporated into any portion of the dendrimer, that is, center core, branched portion or terminal portion.

In these polymer structures, the phosphorescence is emitted from the phosphorescent moiety bonded to the conjugated or non-conjugated skeleton, however, the phosphorescence may be emitted from the conjugated or non-conjugated skeleton itself. The phosphorescent polymer compound for use in the organic light-emitting element of the present invention is preferably a polymer comprising a non-conjugated polymer skeleton to which a phosphorescent moiety is bonded (hereinafter referred to as a "non-conjugated phosphorescent polymer"), for its material design flexibility and also in that the phosphorescence can be relatively easily emitted, that the synthesis is easy and that the solubility

in solvent is high to facilitate preparation of a coating solution.

The non-conjugated phosphorescent polymer consists of a phosphorescence-emitting moiety and a carrier-transporting moiety. Representative examples of the polymer structure include, as shown in Fig. 2, according to the bonded state of phosphorescence-emitting moiety and carrier-transporting moiety, (1) a structure where both the phosphorescence-emitting moiety and the carrier-transporting moiety are present in the polymer main chain, (2) a structure where the phosphorescence-emitting moiety is present on the polymer side chain and the carrier-transporting moiety is present in the polymer main chain, (3) a structure where the phosphorescence-emitting moiety is present in the polymer main chain and the carrier-transporting moiety is present on the polymer side chain, and (4) a structure where both the phosphorescence-emitting moiety and the carrier-transporting moiety are present on the polymer side chain. The polymer structure may have a crosslinked structure.

The non-conjugated phosphorescent polymer may have two or more kinds of phosphorescent moieties (each may be present in the main chain or on the side chain) ormayhave two ormore kinds of carrier-transporting moieties (each may be present in the main chain or on the side chain).

The molecular weight of the non-conjugated phosphorescent polymer is, in terms of the weight average molecular weight, preferably from 1,000 to 100,000, more preferably from 5,000 to 50,000.

As for the phosphorescent moiety, a monovalent group or group having two or more valances of a compound which emits phosphorescence at room temperature may be used, and a monovalent or divalent group of transition metal complex or rare earth metal complex is preferred. Examples of the transition metal for use in the transition metal complex include the first transition element series of the Periodic Table, namely, from Sc of atomic number 21 to Zn of atomic number 30, the second transition element series, namely from Y of atomic number 39 to Cd of atomic number 48, and the third transition element series, namely from Hf of atomic number 72 to Hg of atomic number 80. Examples of the rare earth metal for use in the rare earth metal complex include the lanthanoid series of the Periodic Table, namely, from La of atomic number 57 to Lu of atomic number 71.

Examples of the ligand which can be used for the transition metal complex or rare earth metal complex include ligands described in G. Wilkinson (Ed.), Comprehensive Coordination Chemistry, Plenum Press (1987), and Akio Yamamoto, Yuki Kinzoku Kagaku -Kiso to Oyo- (Organic Metal Chemistry -Fundamentals and Applications-), Shokabo (1982). Among these, preferred are halogen ligands, nitrogen-containing heterocyclic ligands (e.g., phenylpyridine-based ligand, benzoquinoline-based ligand, quinolinol-based ligand, bipyridyl-based ligand, terpyridine-based ligand and phenanthroline-based ligand), diketone ligands (e.g., acetylacetone ligand and dipivaloylmethane ligand), carboxylic acid ligands (e.g., acetic acid ligand), phosphorus ligands (e.g., triphenylphosphine-based ligand and phosphite-based ligand), carbon monoxide ligands, isonitrile ligands and cyano ligands. One metal complex may contain multiple ligands. Also, the metal complex may be a binuclear or polynuclear complex.

As for the carrier-transporting moiety, a monovalent group or a group having two or more valences of a hole-transporting compound, an electron-transporting compound or a bipolar compound which transports both holes and electrons may be used.

Examples of the carrier transporting moiety for hole-transporting include a monovalent or divalent group of carbazole, triphenylamine and TPD (N,N'-diphenyl-N,N'-(3-methylphenyl)-1,1'-biphenyl-4,4'-diamine). Examples of the carrier transporting moiety for electron-transporting include a monovalent or divalent group of quinolinol derivative metal complexes such as $Alq_3$ (aluminum tris-quinolinol), oxadiazole derivatives, triazole derivatives, imidazole derivatives and triazine derivatives.

Examples of the bipolar carrier transporting moiety include a monovalent or divalent group of CBP (4,4'-N,N'-dicarbazole-biphenyl) .

In the organic light-emitting element of the present invention, the light-emitting layer can be formed only of the above-described phosphorescent polymer compound. The light-emitting layer may also be formed of a composition prepared by mixing a phosphorescent polymer compound with another carrier-transporting compound so as to compensate for the carrier transporting property of the phosphorescence-emitting polymer compound. That is, when the phosphorescent polymer compound has a hole transporting property, an electron-transporting compound may be mixed therewith and when the phosphorescent polymer compound has an electron transporting property, a hole-transporting compound may be mixed therewith. The carrier-transporting compound mixed with the phosphorescence-emitting polymer compound may be either a low molecular compound or a polymer compound.

Examples of the low-molecular hole-transporting compound which can be mixed with the phosphorescence-emitting polymer compound include known hole transportingmaterials including triphenylamine derivatives such as TPD (N,N'-diphenyl-N,N'-(3-methylphenyl)-1,1'-biphenyl-4,4'-diamine), $\alpha$-NPD(4,4'-bis[N-(1-naphthyl)-N-phenylamino]biphenyl) and m-MTDATA (4,4',4"-tris(3-methylphenylphenylamino)triphenylamine).

Examples of the polymer hole-transporting compound which can be mixed with the phosphorescence-emitting polymer compound include those obtained by introducing a polymerizable functional group into a polyvinylcarbazole or triphenylamine-based low-molecular compound to convert the low-molecular compound into a polymer compound, such as polymer compounds having a triphenylamine skeleton disclosed in JP-A-8-157575.

Examples of the low-molecular electron-transporting compound which can be mixed with the phosphorescent polymer compound include quinolinol derivative metal complexes such as $Alq_3$ (aluminum tris-quinolinol), oxadiazole derivatives, triazole derivatives, imidazole derivatives and triazine derivatives.

Examples of the polymer electron-transporting compound which can be mixed with the phosphorescence-emitting polymer compound include those obtained by introducing a polymerizable functional group into the above-described low-molecular electron-transporting compound to convert the low-molecular compound into a polymer compound, such as polyPBD disclosed in JP-A-10-1665.

For the purpose of improving the physical properties and the like of the film obtained by film-forming the phosphorescent polymer compound, a composition prepared by mixing a polymer compound not directly participating in the light-emitting property of the phosphorescent polymer compound may be used as the light-emitting material. For example, PMMA (polymethyl methacrylate) or polycarbonate may be mixed so as to impart flexibility to the obtained film.

The thickness of the light-emitting layer is preferably from 1 nm to 1 μm, more preferably from 5 to 300 nm, still more preferably from 10 to 100 nm.

In the organic light-emitting element of the present invention, examples of the hole transporting material for forming the hole transporting layer include known low-molecular hole transporting materials such as triphenylamine derivatives (e.g., TPD (N,N'-dimethyl-N,N'-(3-methylphenyl)-1,1'-biphenyl-4,4'-diamine), α-NPD (4,4'-bis[N-(1-naphthyl)-N-phenylamino]biphenyl), m-MTDATA (4,4',4"-tris(3-methylphenylphenylamino)triphenylamine)) and polyvinylcarbazole.

A polymer hole transporting material can also be used and examples thereof include those obtained by introducing a polymerizable functional group into a triphenylamine-based low-molecular compound to convert it into a polymer compound, such as polymer compounds having a triphenylamine skeleton disclosed in JP-A-8-157575, and polymer materials such as polyparaphenylenevinylene and polydialkylfluorene.

Such a hole transporting material can be used alone but may be used by mixing or stacking it with another hole transporting material.

The thickness of the hole transport layer is preferably from 1 nm to 5 μm, more preferably from 5 nm to 1 μm, still more preferably from 10 to 500 nm.

In the organic light-emitting element of the present invention, examples of the electron transporting material for forming the electron transporting layer include known low-molecular electron transporting materials such as quinolinol derivative metal complexes (e.g., $Alq_3$ (aluminum tris-quinolinol)), oxadiazole derivatives, triazole derivatives, imidazole derivatives and triazine derivatives.

A polymer electron transporting material may also be used and examples thereof include those obtained by introducing a polymerizable functional group into the above-described low-molecular electron-transporting compound to convert it into a polymer compound, such as polyPBD disclosed in JP-A-10-1665.

Such an electron transporting material can be used alone but may be used by mixing or stacking it with another electron transporting material. The thickness of the electron transporting layer is preferably from 1 nm to 5 μm, more preferably from 5 nm to 1 μm, still more preferably from 10 to 500 nm.

The phosphorescence-emitting polymer compound used for the light-emitting layer, the hole transporting material used for the hole transporting layer, and the electron transporting material used for the electron transporting layer each may constitute the layer by itself or by using a polymer material as the binder. Examples of the polymer material used as the binder include polymethyl methacrylate, polycarbonate, polyester, polysulfone and polyphenylene oxide.

The light-emitting layer, hole transporting layer and electron transporting layer may be formed by resistance heating vapor deposition method, electron beam vapor deposition method, sputtering method, inkjetmethod, spincoatingmethod, dipcoatingmethod, printingmethod, spray method, dispenser method or the like. In the case of a low-molecular compound, the resistance heating vapor deposition method or electron beam vapor deposition method is mainly used and in the case of a polymer compound, the inkjet method or spin coating method is mainly used.

For the purpose of allowing for efficient recombination of holes with electrons by preventing holes from passing through the light-emitting layer, a hole-blocking layer may be provided in adjacent to the cathode side of the light-emitting layer. For this layer, a compound having a deeper HOMO level than that of the light-emitting material can be used and examples thereof include triazole derivatives, oxadiazole derivatives, phenanthroline derivatives and aluminum complexes.

Furthermore, for the purpose of preventing an exciton from being deactivated by the cathode metal, an exciton-blocking layer may be provided in adjacent to the cathode side of the light-emitting layer. For this layer, a compound having a larger excited triplet energy than that of the light-emitting material can be used and examples thereof include triazole derivatives, phenanthroline derivatives and aluminum complexes.

As for the anode material which can be used for the light-emitting element of the present invention, a known transparent electrically conducting material may be used and examples thereof include electrically conducting polymers such as ITO (indium tin oxide), tin oxide, zinc oxide, polythiophene, polypyrrole and polyaniline. The surface resistance of the electrode formed of this transparent electrically conducting material is preferably from 1 to 50 Ω/square (ohm/square). Such an anode material maybe film-formed by the electron beam vapor deposition method, sputtering method, chemical reaction method, coating method or the like. The thickness of the anode is preferably from 50 to 300 nm.

As for the cathodematerial for the organic light-emitting element of the present invention, a material having a low work function and being chemically stable is used and examples thereof include known cathode materials such as A1, MgAg alloy and Al-alkali metal alloy (e.g., AlLi and AlCa). However, the work function is preferably 2.9 eV or more in consideration for chemical stability. Such a cathode material may be film-formed by the resistance heating vapor deposition method, electron beam vapor deposition method, sputtering method, ion plating method or the like. The thickness of the cathode is preferably from 10 nm to 1 μm, more preferably from 50 to 500 nm.

For the purpose of decreasing the barrier against electron injection from the cathode into the organic layer and thereby elevating the electron injection efficiency, a metal layer having a work function lower than the cathode layer may be inserted between the cathode and an organic layer adjacent to the cathode. Examples of the metal having such a low work function, which can be used for this purpose, include alkali metals such as Na, K, Rb and Cs, alkaline earth metals such as Sr and Ba, and rare earth metals such as Pr, Sm, Eu and Yb. An alloy or a metal compound may also be used if its work function is lower than that of the cathode. Such a cathode buffer layer may be film-formed by the vapor deposition method or sputtering method. The thickness of the cathode buffer layer is preferably from 0.05 to 50 nm, more preferably from 0.1 to 20 nm, still more preferably from 0.5 to 10 nm.

The cathode buffer layer may also be formed of a mixture of the above-described material having a low work function with an electron transporting material. As for the electron transport material used here, the organic compounds described above for use in the electron transporting layer can be used. In this case, the film formation may be performed by the co-deposition method. Also, in the case where the film formation can be performed by coating a solution, a film formation method such as spin coating method, dip coating method, inkjet method, printing method, spray method and dispenser method may be used. In this case, the thickness of the cathode buffer layer is preferably from 0.1 to 100 nm, more preferably from 0.5 to 50 nm, stillmorepreferably from 1 to 20 nm.

As for the substrate of the organic light-emitting element according to the present invention, an insulating substrate transparent to light at the emission wavelength of the light-emitting material, specifically, a glass or a known material such as transparent plastics including PET (polyethylene terephthalate) and polycarbonate, can be used.

## BEST MODE FOR CARRYING OUT THE INVENTION

The electroconductive composition and the organic light emitting device according to the present invention are to be described with reference to (1) Examples and Comparative Examples for the electroconductive composition, (2) Synthesis Examples for the phosphorescence light emitting monomer, phosphorescent copolymer and electron-transporting polymer compound for use in the organic light emitting device, and (3) Examples and Comparative Examples for the organic light emitting device, but the present invention is not restricted to the following examples.

In the following examples of electroconductive compositions, an electroconductive coating film was prepared by dropping 5 ml of the electroconductive coating material on a glass substrate and then rotationally coating the same at 800 rpm or 600 rpm by using a Spinner 1H-III (manufactured by Kyoei Semiconductor Co.). The surface resistance value (Rs) of the electroconductive coating film was measured by a surface resistance measuring instrument, MEGARESTOR MODEL HT-301 (manufactured by Shishido Electrostatic Co. Ltd.)). The film thickness was measured with a stylus profilometer (Dektak-3030: manufactured by ULVAC). Among the conductive polymer compounds used in each of the examples, poly(5-sulfoisothianaphten-1,3-yl) was synthesized with references to the method described in JP-A-1995-48436.

Further, in the following Synthesis Examples, Examples and Comparative Examples regarding the organic light emitting devices, apparatus used for analysis are as described below and commercially available products (special grade) were used as reagents with no purification unless otherwise specified.

1) $^1$H-NMR
JNM EX 270, 270 MHz, manufactured by JEOL Ltd.
Solvent: deuterated chloroform
2) Elemental analysis device
Model CHNS-932, manufactured by LECO Co.
3) GPC measurement (molecular weight measurement)
Column: Shodex KF-G+KF804L+KF802+KF801,
Eluent: Tetrahydrofuran (THF),
Temperature: 40°C,
Detector: RI (Shodex RI-71).
4) ICP elemental analysis
ICPS 8000, manufactured by Shimadzu Corporation

Example 1: Preparation of electroconductive coating material

An electroconductive coating material was prepared by adding 0.7mass parts of poly(5-sulfoisothianaphthene-1,3-diyl) (hereinafter simply referred to as "PolySITN") and 1 mass part of hydroxypropyl cellulose (hereinafter simply referred to as "HPC") (CAS#9004-64-2, manufactured by Acros Organics Co.) to 100 mass parts of water.

After rotationally coating 5 ml of the electroconductive coating material of the present invention on a glass substrate, it was dried by heating at 150°C for 10 minutes to form an electroconductive coating film on a surface of a glass plate of 60 X 60 X 1.1 mm (#1737: manufacture by Corning Inc.). After the coating film was cooled for 30 minutes, the surface resistance Rs and the film thickness were measured. Then the electroconductivity was calculated.

Examples 2 to 8: Preparation of electroconductive coating material

Using electroconductive coating material prepared by using polySITN with hydroxypropyl cellulose (HPC) (in Examples 2-5), polycarboxylic acid-type polymer surfactant (POIZE)(in Example 6), polyvinyl acetamide (PNVA) (in Example 7) or polyethylene oxide (PEO) (in Example 8) as additives at the respective ratios shown in Table 1, electroconductive coating films using the electroconductive coating materials were formed in the same manner as in Example 1 and the electroconductivity values of the electroconductive films are shown in Table 1.

Comparative Example 1: Preparation of comparative electroconductive coating material

An electroconductive coating material was prepared by adding 3 mass parts of PolySITN to 100 mass parts of water and an electroconductive coating film was formed in the same manner as in Example 1. The electroconductivity value of the film is shown in Table 1.

Table 1

| | PolySITN wt% | additive type | amount % | dilution ratio | film thickness nm | surface resistance Ω/□ | electro-conductivity $m(\Omega\ cm)^{-1}$ | adjusted value $m(\Omega\ cm)^{-1}$ | electro-conductivity increase ratio |
|---|---|---|---|---|---|---|---|---|---|
| Example 1 | 0.70 | HPC | 0.05 | 0.93 | 19 | $4.53 \times 10^5$ | 1162 | 1278 | 1.91 |
| Example2 | 0.70 | HPC | 0.20 | 0.78 | 20 | $4.42 \times 10^5$ | 1131 | 1490 | 2.23 |
| Example3 | 0.70 | HPC | 0.10 | 0.88 | 16 | $4.45 \times 10^5$ | 1404 | 1604 | 2.40 |
| Example4 | 0.70 | HPC | 0.50 | 0.58 | 27 | $3.42 \times 10^5$ | 1083 | 1836 | 2.74 |
| Example5 | 0.70 | HPC | 1.00 | 0.41 | 58 | $6.85 \times 10^4$ | 2517 | 6113 | 9.14 |
| Example6 | 0.50 | POIZE | 0.50 | 0.50 | 70 | $1.94 \times 10^5$ | 736 | 1473 | 2.20 |
| Example7 | 0.50 | PNVA | 0.50 | 0.50 | 17 | $5.71 \times 10^5$ | 1060 | 2120 | 3.17 |
| Example8 | 0.50 | PEO | 0.50 | 0.50 | 24 | $8.52 \times 10^4$ | 4828 | 9656 | 14.44 |
| Comparative Example 1 | 3 | - | - | 1 | 167 | $8.97 \times 10^4$ | 669 | 669 | - |

1~5) HPC:manufactured by Acros Organics; CAS#9004-64-2
6) POIZE: manufactured by KAO CORPORATION:POIZE532A
7) PNVA: manufactured by SHOWA DENKO K.K; GE-191 LH
8) PEO: manufactured by Acros Organics:CAS#25322-68-3

From the results shown in Table 1, it can be seen that the electroconductivity was remarkably enhanced in the coating films of the electroconductive compositions where an aqueous solvent-soluble resin was added according to the present invention, as compared to the film formed of the electroconductive polymer alone. Moreover, in comparing increase ratios in electroconductivity by dividing the adjusted electroconductivity value obtained by dividing the electroconductivity by the dilution ratio in each of the Examples by the adjusted electroconductivity value of Comparative Example 1 where no additive was used, it is revealed that electroconductivity enhancement by addition of the aqueous solvent-soluble resin is marked .

Synthesis Example 1: Synthesis of phosphorescent light emitting monomer: [6-(4-vinylphenyl)-2,4-hexane dionate] bis (2-phenylpyridine) iridium (III) (hereinafter referred to as IrPA)

Synthesis was conducted in accordance with the method as described in JP-A-2003-113246, to obtain IrPA.

Synthetic Example 2: Synthesis of phosphorescent light emitting copolymer: Poly(N-vinylcarbazole-co-[6-(4-vinylphenyl)-2,4-hexanedionate] bis(2-phenylpyridine) iridium (III)) (hereinafter referred to as poly(VCz-co-IrPA))

The copolymer described above was synthesized as a light emitting material, containing IrPA as a unit having a light emitting property and N-vinyl carbazole as a unit having a hole transporting property.

1.55 g (8.0 mmol) of N-vinyl carbazole, 29 mg (0.04 mmol) of $Ir(ppy)_2$ [1-(StMe)-acac], and 13 mg (0.08 mmol) of AIBN were dissolved in 40 ml of dehydrated toluene, and further argon was blown thereto for 1 hour. The solution was heated to a temperature of 80°C to start polymerization reaction, and stirred as it was for 8 hours. After cooling, the reaction solution was added dropwise to 250 ml of methanol to precipitate a polymerizate, which was recovered through filtration. Further, the recovered polymeric material was dissolved in 25 ml of chloroform, and the solution was added dropwise in 250 ml of methanol to re-precipitate for purification, and then dried *in vacuo* at 60°C for 12 hours to obtain 1.14 g of an aimed product of poly (VCz-co-IrPA) (recovery rate: 72%). The number average molecular weight of the polymer was 4800, and the weight average molecular weight thereof was 11900 in terms of polystyrene (according to GPC measurement) . Further, the content of the Ir complex portion as a phosphorescent light emitting portion was 0.62 mol% (according to ICP elemental analysis).

Synthesis Example 3: Synthesis of electron transporting polymer compound: polyPBD (following structural formula (4)).

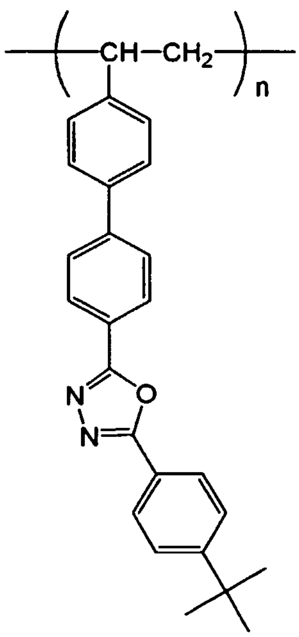

(4)

The synthesis was conducted in accordance with the method described in JP-A-1998-1665, to obtain polyTPD. The number average molecular weight was 32400, and the weight average molecular weight thereof was 139100 in terms of polystyrene (according to GPC measurement).

Example 9: Preparation of an organic light emitting element (fluorescent) using the electroconductive coating material prepared in Example 1 as an anode buffer layer, and light emitting properties thereof

An organic light emitting element was prepared by using a ITO (indium tin oxide) -coated substrate (manufactured by Nippo Electric Co. Ltd.) which was a 25-mm-square glass substrate with two 4-mm-width ITO electrodes formed in stripes as an anode on one surface of the substrate. First, an electroconductive coating material for forming an anode buffer layer was prepared. Namely, the aqueous solution implemented in Example 1 was prepared. The aqueous solution was coated on the substrate with ITO by a spin coater (800 rpm, 60 sec) and dried at 200°C for 10 min to form an anode buffer layer. The film thickness of the obtained anode buffer layer was about 51 nm. Then, a coating solution for forming a light emitting layer was prepared. That is, 45 mg of poly (2-methoxy-5- (2' -ethylhexyloxy) -1, 4-phenylene vinylene) (hereinafter referred to asMEH-PPV) (ADS100REmanufacturedbyAmerican Dye Source Inc.) was dissolved in 2955 mg of a tetrahydrofuran (special grade, manufactured by Wako Pure Chemical Industries Ltd., and the obtained solution was subjected to filtration through a filter having a pore size of 0.2 μm to obtain a coating solution. Then, the prepared coating solution was coated on the anode buffer layer by a spin coat method under the conditions of 3000 rpm, for a coating time of 30 seconds, dried at 140°C for 30 minutes to form a light emitting layer. The film thickness of the obtained light emitting layer was about 100 nm. Then, the substrate on which the light emitting layer was formed was placed in a vapor deposition apparatus, calcium was vapor deposited at a vapor deposition rate of 0.1 nm/s to 25 nm thickness and then aluminum was vapor deposited as a cathode at a vapor deposition rate of 1 nm/s to a thickness of 250 nm. Then, the layers of calcucium and aluminum were formed in the form of two stripes each of 3 mm width perpendicular to the longitudinal direction of the anode. Finally, lead wires were attached to both of the anode and the cathode in an argon atmosphere, to obtain four organic light emitting elements each of 4 mm length x 3 mm width per one substrate.

The above organic EL element was driven by applying voltage using a programmable direct-current voltage/current source TR 6143 manufactured by Advantest Co. to emit light and the emission luminance of the device was measured by using a luminance meter BM-8 manufactured by TOPCON Corp. As a result, the maximum luminance, maximum external quantum efficiency and the brightness half-life from the initial luminance of 100 cd/$m^2$ were as shown in Table 2 (Each of the values is an average value of four elements formed on one substrate).

Example 10: Preparation of an organic light emitting element (phosphorescent light emission) having the electroconductive coating material prepared in Example 1 as an anode buffer layer, and light emitting properties thereof.

An organic light emitting element was prepared in the same manner as in Example 3 except that the light emitting layer was formed as described below, and the light emission characteristics were evaluated.

63.0 mg of the poly (VCz-co-IrPA) synthesized in Synthesis Example 2 and 27.0 mg of the polyPBD synthesized in synthesis Example 3 were dissolved in 2910 mg of toluene (special grade, manufactured by Wako Pure Chemical Industries Ltd.), and the obtained solution was subjected to filtration through a filter having a pore size of 0.2 μm to obtain a coating solution. The coating solution was coated on an anode buffer layer by a spin coater (at 3000 rpm, for 30 seconds), dried at 140°C for 30 min to form a light emitting layer. The film thickness of the obtained light emitting layer was about 80 nm.

As a result, the maximum luminance, the maximum external quantum efficiency, the brightness half-life from the initial luminance of 100 cd/$m^2$ were as shown in Table 2 (Each of the values is an average value of four elements formed on one substrate).

Comparative Example 2: Preparation of an organic light emitting element (fluorescent) using a mixture of poly(3,4-ethylene dioxythiophene) and polystyrene sulfonic acid as an anode buffer layer, and light emitting properties thereof.

An organic light emitting element was prepared in the same manner as in Example 3 except that the anode electrode buffer layer was formed as described below, and the light emission characteristics were evaluated.

An aqueous solution of a mixture of poly(3,4-ethylene dioxythiophene) and polystyrene sulfonic acid (trade name: "Baytron CH8000", manufactured by Bayer Ltd.) was used as a coating solution for forming the anode buffer layer. While the solid content concentration of the coating solution was 2.8 mass%, it was diluted with water so that the concentration was 1 mass%. The coating solution was coated on a substrate with ITO by a spin coater (at 3500 rpm, for 40 seconds), dried at 140°C for 30 minutes, to form an anode buffer layer. The thickness of the obtained anode buffer layer was about 50 nm.

As a result, the maximum luminance and the brightness half-life from the initial luminance of 100 cd/$m^2$ were as shown in Table 1 (Each of the values is an average value of four elements formed on one substrate).

Comparative Example 3: Preparation of an organic light emitting element (phosphorescent) having a mixture of poly (3,4-ethylene dioxythiophene) and polystyrene sulfonic acid as an anode buffer layer, and light emitting properties thereof.

An organic light emitting element was prepared in the same manner as in Comparative Example 1 except that the light emitting layer was formed as described below and the emission characteristics were evaluated.

That is, 63.0 mg of the poly (VCz-co-IrPA) synthesized in Synthesis Example 2 and 27.0 mg of the polyPBD synthesized in Synthesis Example 3 were dissolved in 2910 mg of toluene (special grade, manufactured by Wako Pure Chemical Industries Ltd.), and the obtained solution was subjected to filtration through a filter having a pore size of 0.2 μm to obtain a coating solution. The coating solution was coated on an anode buffer layer by a spin coater (at 3000 rpm, for 30 sec), dried at 140°C for 30 min to form a light emitting layer. The film thickness of the obtained light emitting layer was about 80 nm.

As a result, the maximum luminance, the maximum external quantum efficiency, the brightness half-life from the initial luminance of 100 $cd/m^2$ were as shown in Table 2 (Each of the values is an average value of four devices formed on one substrate).

Table 2

| | anode buffer layer | light emitting layer | maximum luminance (cd/m$^2$) | maximum external quantum efficiency (%) | brightness half-life (hr@100cd/m$^2$) |
|---|---|---|---|---|---|
| Example 9 | PolySITN+HPC | MEH-PPV | 7,500 | 2.2 | 7,400 |
| Example 10 | PolySITN+HPC | Poly(VCz-co-IrPA)+polyPBD | 16,200 | 5.8 | 77 |
| Comparative example 2 | Baytron CH8000 | MEH-PPV | 4,100 | 1.4 | 1,900 |
| Comparative example 3 | Baytron CH8000 | poly(VCz-co-IrPA)+polyPBD | 8,300 | 3.7 | 22 |

## INDUSTRIAL APPLICABILITY

The present invention provides an electroconductive composition in which an aqueous solvent-soluble resin is added as an additive capable of improving the electroconductivity of existing soluble conductive polymers at a reduced cost conveniently. The electroconductive composition according to the present invention is applicable in surface antistatic treatment of low resistance, without being affected by circumstance such as dry conditions, unlike ionic surface antistatic treatment where surfactant is applied to a portion to be treated by coating onto a non-electroconductive substrate.

Specific examples of applications where the present invention can be used include IC cartridges and containers used for semiconductor-relatedmaterials, packaging films for electronic parts, covers for measuring instruments, CRT surfaces and FPD surfaces, which require antistatic treatment, and also include agents for preventing charge-up caused in electron beam lithography process, although not particularly limited to such application examples. Further, it is also applicable to the anode buffer layer as a constituent material of organic EL elements.

## Claims

1. An electroconductive composition comprising an aqueous solvent-soluble electroconductive polymer containing a chemical structure shown by formula (1)

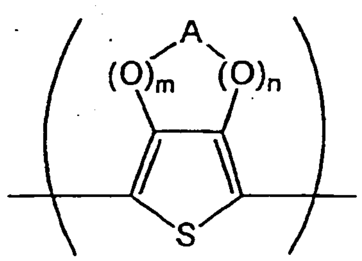

(1)

wherein m and n each independently represent 0 or 1, A represents an alkylene or alkenylene group having 1 to 4 carbon atoms (which may have two double bonds) which has at least one substituent represented by $-B-SO_3^-M^+$, and the alkylene group and the alkenylene group may have each as a substituent, a linear or branched, saturated or unsaturated hydrocarbon group having 1 to 20 carbon atoms, a linear or branched, saturated or unsaturated alkoxy group having 1 to 20 carbon atoms, a linear or branched alkylester group having 1 to 20 carbon atoms, a hydroxyl group, a halogen atom, a nitro group, a cyano group, a trihalomethyl group or a phenyl group which may be substituted, B represents $-(CH_2)_p-(O(CH_2)_q)_r-$, p is 0 or an integer of 1 to 5, q is an integer of 1 to 3, and r is 0 or an integer of 1 to 3, and $M^+$ represents $H^+$, an alkali metal ion or a quaternary ammonium ion, and an aqueous solvent-soluble resin, which is at least one selected from a group consisting of cellulose ether and polyethylene oxide, wherein the increase ratio in the electroconductivity in the composition is 1 or more based on the electroconductivity of the aqueous solvent-soluble electroconductive polymer.

2. The electroconductive composition as claimed in claim 1, wherein the aqueous solvent-soluble electroconductive polymer is a water soluble electroconductive polymer containing a chemical structure represented by the following general formula (2)

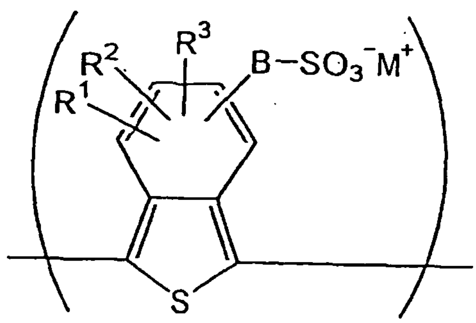

(2)

wherein $R^1$ to $R^3$ each independently represent a hydrogen atom, a linear or branched, saturated or unsaturated hydrocarbon group having 1 to 20 carbon atoms, a linear or branched, saturated or unsaturated alkoxy group having 1 to 20 carbon atoms, a linear or branched alkyl ester group having 1 to 20 carbon atoms, a hydroxyl group, a halogen atom, a nitro group, a cyano group, a trihalomethyl group, a phenyl group which may be substituted, or a $-B-SO_3^-M^+$ group, the alkyl group, the alkoxy group or the alkyl ester group as $R^1$, $R^2$ and $R^3$ described above may have, in the chain thereof, a carbonyl bond, an ether bond, an ester bond, a sulfonate ester bond, an amide bond, a sulfonamide bond, a sulfide bond, a sulfinyl bond, a sulfonyl bond or an imino bond, B represents $-(CH_2)_p-(O(CH_2)_q)_r-$, p is 0 or an integer of 1 to 5, q is an integer of 1 to 3, r is 0 or an integer of 1 to 3, and $M^+$ represents $H^+$, an alkali metal ion or a quaternary ammonium ion.

**3.** The electroconductive composition as claimed in claim 1 or 2, wherein the cellulose ether is hydroxypropyl cellulose.

**4.** The electroconductive composition as claimed in claim 1, 2 or 3, wherein 0.05 to 20 parts by mass of the aqueous solvent-soluble resin is contained based on 1 part by mass of the aqueous solvent-soluble electroconductive polymer.

**5.** An electroconductive coating material using the electroconductive composition according to any one of claims 1 to 4 .

**6.** An electroconductive coating film using the electroconductive composition according to any one of claims 1 to 4.

**7.** A coated article which is coated with the electroconductive composition according to any one of claims 1 to 4.

**8.** The coated article as claimed in claim 7, wherein the surface of the base substrate is a coating of a photosensitive composition or a coating of a composition sensitive for charged particle beam.

**9.** A method for forming a pattern, using the electroconductive coating film according to claim 6.

**10.** An organic electronic element using an anode buffer layer containing the electroconductive composition according to any one of claims 1 to 4.

**11.** An organic light emitting element using an anode buffer layer containing the electroconductive composition according to any one of claims 1 to 4.

**12.** The organic light emitting element as claimed in claim 11, wherein the light emitting layer of the organic light emitting element comprises a fluorescent polymer.

**13.** The organic light emitting element as claimed in claim 11, wherein the light emitting layer of the organic light emitting element comprises a phosphorescent polymer.

## Patentansprüche

**1.** Elektroleitfähige Zusammensetzung, die ein in einem wässrigen Lösungsmittel lösliches elektroleitfähiges Polymer, welches eine chemische Struktur der Formel (1) aufweist,

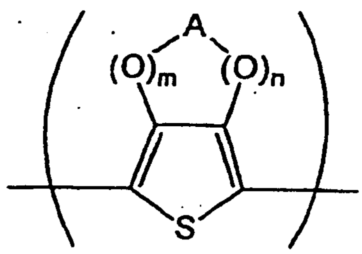

(1)

worin m und n jeweils unabhängig voneinander 0 oder 1 darstellen, A eine Alkylen- oder Alkenylengruppe mit 1 bis 4 Kohlenstoffatomen (die zwei Doppelbindungen aufweisen können) darstellt, die mindestens einen Substituenten $-B-SO_3^-M^+$ aufweist, und die Alkylengruppe und die Alkenylengruppe jeweils als einen Substituenten eine lineare

oder verzweigte, gesättigte oder ungesättigte Kohlenwasserstoffgruppe mit 1 bis 20 Kohlenstoffatomen, eine lineare oder verzweigte, gesättigte oder ungesättigte Alkoxygruppe mit 1 bis 20 Kohlenstoffatomen, eine lineare oder verzweigte Alkylestergruppe mit 1 bis 20 Kohlenstoffatomen, eine Hydroxygruppe, ein Halogenatom, eine Nitrogruppe, eine Cyangruppe, eine Trihalogenmethylgruppe oder eine Phenylgruppe, die substituiert sein kann, aufweisen können, B $-(CH_2)_p-(O(CH_2)_q)_r-$ darstellt, p 0 oder eine ganze Zahl von 1 bis 5 ist, q eine ganze Zahl von 1 bis 3 ist und r 0 oder eine ganze Zahl von 1 bis 3 ist, und $M^+$ $H^+$, ein Alkalimetallion oder ein quartäres Ammoniumion darstellt, und

ein in einem wässrigen Lösungsmittel lösliches Harz enthält, das mindestens ein Mitglied der Gruppe ist, die aus Celluloseether und Polyethylenoxid besteht, wobei der Faktor der Verstärkung der Elektroleitfähigkeit in der Zusammensetzung 1 oder mehr, bezogen auf die Leitfähigkeit des in einem wässrigen Lösungsmittel löslichen elektroleitfähigen Polymers, ist.

2. Elektroleitfähige Zusammensetzung nach Anspruch 1, wobei das in einem wässrigen Lösungsmittel lösliche elektroleitfähige Polymer ein wasserlösliches elektroleitfähiges Polymer ist, das eine chemische Struktur der folgenden allgemeinen Formel (2) enthält,

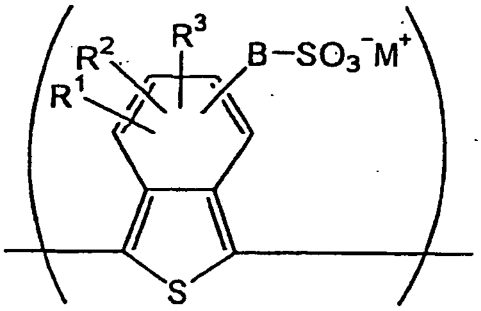

(2)

worin $R^1$ bis $R^3$ jeweils unabhängig voneinander ein Wasserstoffatom, eine lineare oder verzweigte, gesättigte oder ungesättigte Kohlenwasserstoffgruppe mit 1 bis 20 Kohlenstoffatomen, eine lineare oder verzweigte, gesättigte oder ungesättigte Alkoxygruppe mit 1 bis 20 Kohlenstoffatomen, eine lineare oder verzweigte Alkylestergruppe mit 1 bis 20 Kohlenstoffatomen, eine Hydroxygruppe, ein Halogenatom, eine Nitrogruppe, eine Cyangruppe, eine Trihalogenmethylgruppe, eine Phenylgruppe, die substituiert sein kann, oder eine $-B-SO_3^-M^+$-Gruppe darstellen, die vorstehend als $R^1$, $R^2$ und $R^3$ beschriebene Alkylgruppe, Alkoxygruppe oder Alkylestergruppe in ihrer Kette eine Carbonylbindung, eine Etherbindung, eine Esterbindung, eine Sulfonatesterbindung, eine Amidbindung, eine Sulfonamidbindung, eine Sulfidbindung, eine Sulfinylbindung, eine Sulfonylbindung oder eine Iminobindung aufweisen kann, B $-(CH_2)_p-(O(CH_2)_q)_r-$ darstellt, p 0 oder eine ganze Zahl von 1 bis 5 ist, q eine ganze Zahl von 1 bis 3 ist, r 0 oder eine ganze Zahl von 1 bis 3 ist und $M^+$ $H^+$, ein Alkalimetallion oder ein quartäres Ammoniumion darstellt.

3. Elektroleitfähige Zusammensetzung nach Anspruch 1 oder 2, wobei der Celluloseether Hydroxypropylcellulose ist.

4. Elektroleitfähige Zusammensetzung nach Anspruch 1, 2 oder 3, wobei 0,05 bis 20 Massenteile des in einem wässrigen Lösungsmittel löslichen Harzes, bezogen auf 1 Massenteil des in einem wässrigen Lösungsmittel löslichen elektroleitfähigen Polymers, enthalten sind.

5. Elektroleitfähiges Beschichtungsmaterial, welches die elektroleitfähige Zusammensetzung nach einem der Ansprüche 1 bis 4 verwendet.

6. Elektroleitfähiger Beschichtungsfilm, welcher die elektroleitfähige Zusammensetzung nach einem der Ansprüche 1 bis 4 verwendet.

7. Beschichteter Gegenstand, der mit der elektroleitfähigen Zusammensetzung nach einem der Ansprüche 1 bis 4 beschichtet ist.

8. Beschichteter Gegenstand nach Anspruch 7, wobei die Oberfläche des Grundsubstrats eine Beschichtung aus einer lichtempfindlichen Zusammensetzung oder eine Beschichtung aus einer gegen Ladungsteilchenstrahlen empfindlichen Zusammensetzung ist.

9. Verfahren zum Erzeugen eines Musters, welches den elektroleitfähigen Beschichtungsfilm nach Anspruch 6 verwendet.

10. Organisches elektronisches Element, welches eine Anodenpufferschicht verwendet, welche die elektroleitfähige Zusammensetzung nach einem der Ansprüche 1 bis 4 enthält.

11. Organisches lichtemittierendes Element, welches eine Anodenpufferschicht verwendet, welche die elektroleitfähige Zusammensetzung nach einem der Ansprüche 1 bis 4 enthält.

12. Organisches lichtemittierendes Element nach Anspruch 11, wobei die lichtemittierende Schicht aus dem organischen lichtemittierenden Element ein fluoreszierendes Polymer enthält.

13. Organisches lichtemittierendes Element nach Anspruch 11, wobei die lichtemittierende Schicht des organischen lichtemittierenden Elements ein phosphoreszierendes Polymer enthält.

**Revendications**

1. Composition électroconductrice comprenant un polymère électroconducteur soluble en solvant aqueux contenant une structure chimique représentée par la formule (1)

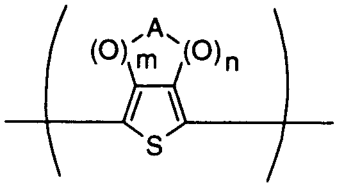

(1)

où m et n représentent chacun indépendamment 0 ou 1, A représente un groupe alkylène ou alcénylène ayant 1 à 4 atomes de carbone (qui peut avoir deux doubles liaisons) qui a au moins un substituant représenté par $-B-SO_3^-M^+$, et le groupe alkylène et le groupe alcénylène peuvent avoir chacun comme substituant un groupe hydrocarboné saturé ou insaturé, linéaire ou ramifié, ayant 1 à 20 atomes de carbone, un groupe alcoxy saturé ou insaturé, linéaire ou ramifié, ayant 1 à 20 atomes de carbone, un groupe alkylester linéaire ou ramifié ayant 1 à 20 atomes de carbone, un groupe hydroxyle, un atome d'halogène, un groupe nitro, un groupe cyano, un groupe trihalogénométhyle ou un groupe phényle qui peut être substitué, B représente $-(CH_2)_p-(O(CH_2)_q)_r-$, p est 0 ou un entier de 1 à 5, q est un entier de 1 à 3, et r est 0 ou un entier de 1 à 3, et $M^+$ représente $H^+$, un ion de métal alcalin ou un ion d'ammonium quaternaire, et une résine soluble en solvant aqueux, qui est au moins une choisie dans un groupe consistant en un éther de cellulose et un poly(oxyde d'éthylène), où le rapport d'augmentation de l'électroconductivité dans la composition et 1 ou plus sur la base de l'électroconductivité du polymère électroconducteur soluble en solvant aqueux.

2. Composition électroconductrice selon la revendication 1 où le polymère électroconducteur soluble en solvant aqueux est un polymère électroconducteur soluble dans l'eau contenant une structure chimique représentée par la formule générale (2) suivante :

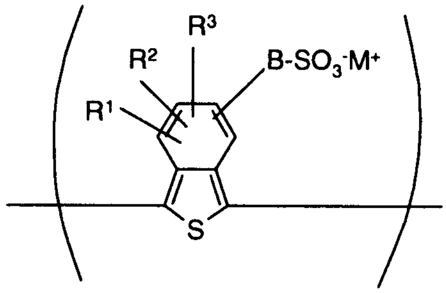

(2)

où $R^1$ à $R^3$ représentent chacun indépendamment un atome d'hydrogène, un groupe hydrocarboné saturé ou insaturé, linéaire ou ramifié, ayant 1 à 20 atomes de carbone, un groupe alcoxy saturé ou insaturé, linéaire ou ramifié, ayant 1 à 20 atomes de carbone, un groupe alkylester linéaire ou ramifié ayant 1 à 20 atomes de carbone, un groupe hydroxyle, un atome d'halogène, un groupe nitro, un groupe cyano, un groupe trihalogénométhyle, un groupe phényle qui peut être substitué, ou un groupe $-B-SO_3^-M^+$, le groupe alkyle, le groupe alcoxy ou le groupe alkylester en tant que $R^1$, $R^2$ et $R^3$ décrits ci-dessus peut avoir, dans sa chaîne, une liaison carbonyle, une liaison éther, une liaison ester, une liaison ester sulfonate, une liaison amide, une liaison sulfonamide, une liaison sulfure, une liaison sulfinyle, une liaison sulfonyle ou une liaison imino, B représente $-(CH_2)_p-(O(CH_2)_q)_r-$, p est 0 ou un entier de 1 à 5, q est un entier de 1 à 3, r est 0 ou un entier de 1 à 3, et $M^+$ représente $H^+$, un ion de métal alcalin ou un ion d'ammonium quaternaire.

**3.** Composition électroconductrice selon la revendication 1 ou 2 où l'éther de cellulose est l'hydroxypropylcellulose.

**4.** Composition électroconductrice selon la revendication 1, 2 ou 3, où 0,05 à 20 parties en masse de résine soluble en solvant aqueux sont contenues par partie en masse de polymère électroconducteur soluble en solvant aqueux.

**5.** Matériau de revêtement électroconducteur utilisant la composition électroconductrice selon l'une quelconque des revendications 1 à 4.

**6.** Film de revêtement électroconducteur utilisant la composition électroconductrice selon l'une quelconque des revendications 1 à 4.

**7.** Article revêtu qui est revêtu avec la composition électroconductrice selon l'une quelconque des revendications 1 à 4.

**8.** Article revêtu selon la revendication 7 où la surface du substrat de base est un revêtement d'une composition photosensible ou un revêtement d'une composition sensible à un faisceau de particules chargées.

**9.** Procédé de formation d'un motif utilisant le film de revêtement électroconducteur selon la revendication 6.

**10.** Elément électronique organique utilisant une couche de tampon d'anode contenant la composition électroconductrice selon l'une quelconque des revendications 1 à 4.

**11.** Elément émetteur de lumière organique utilisant une couche de tampon d'anode contenant la composition électroconductrice selon l'une quelconque des revendications 1 à 4.

**12.** Elément émetteur de lumière organique selon la revendication 11 où la couche émettrice de lumière de l'élément émetteur de lumière organique comprend un polymère fluorescent.

**13.** Elément émetteur de lumière organique selon la revendication 11 où la couche émettrice de lumière de l'élément émetteur de lumière organique comprend un polymère phosphorescent.

Fig.1

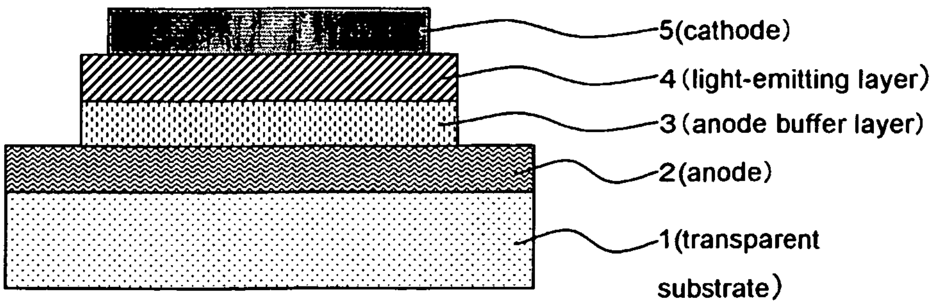
5(cathode)
4 (light-emitting layer)
3 (anode buffer layer)
2 (anode)
1 (transparent
substrate)

Fig.2

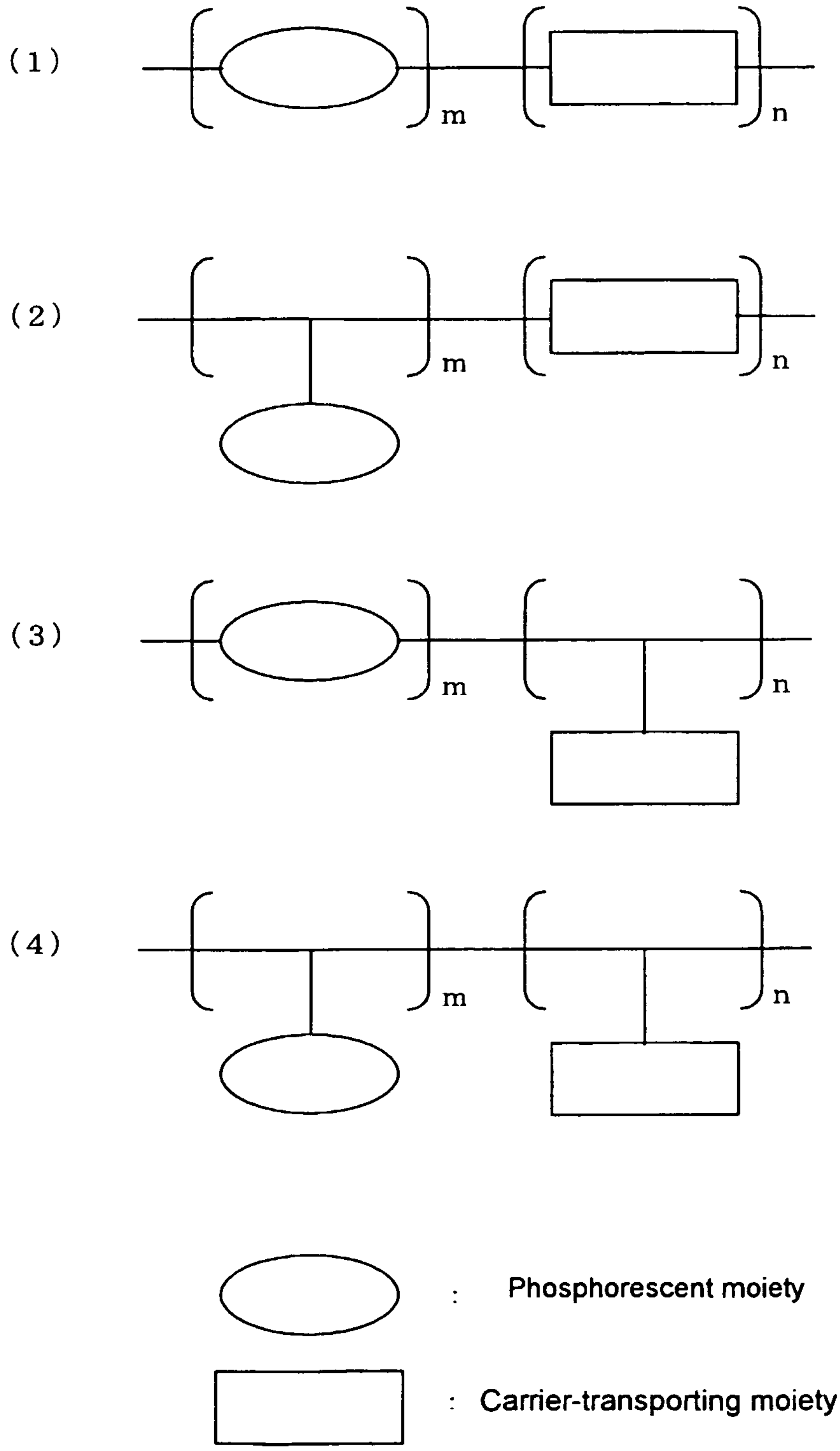
(1)
m
n
(2)
m
n
(3)
m
n
(4)
m
n
: Phosphorescent moiety
: Carrier-transporting moiety

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000095970 A
- JP 2003213148 A
- JP HEI11291410 A
- JP 2003509816 A
- WO 01018888 A
- JP 10239715 A, Showa Denko K. K.
- US 5688873 A, Saida
- US 19971118 A
- JP 2001270999 A
- JP 8157575 A
- JP 10001665 A
- JP 7048436 A
- JP 2003113246 A


### Non-patent literature cited in the description


- WPI. 2002-078319
- **HIROSHI OMORI.** *Oyo Butsuri,* 2001, vol. 70 (12), 1419-1425